# EUROPEAN PATENT APPLICATION

(11) **EP 4 773 622 A1**
(43) Date of publication of application: **08.07.2026**
(21) Application number: 25226703.4
(22) Date of filing: 23.12.2025
(51) Int. Cl.: H04Q 1/02, H05K 7/18

(54) **OUTSIDE CABINET ASSEMBLY**

(30) Priority: 23.12.2024 IN 202421102188; 19.12.2025 US 202519427810
(71) Applicant: Vertiv Corporation, Westerville, OH 43082 (US)
(72) Inventor: CHARAPALE, Utkarsh Diliprao, Westerville, 43082 (US); RATCLIFF, Gregory Wade, Westerville, 43082 (US); DE JESUS, Christopher A., Westerville, 43082 (US)
(74) Representative: Ambroz, Simon

(57) **Abstract**

An outside cabinet assembly is disclosed. A cavity is formed under ground. An enclosure is received in the cavity. An equipment cabinet is received within the enclosure and configured to house electronic components. An environmental control unit (ECU) is thermally coupled to the equipment cabinet. A utility fluid conveyance (UFC) is disposed outside the enclosure. A thermal transfer system (TTS) is in fluid or thermal communication with the ECU and extending from the enclosure to the UFC disposed outside the enclosure. The TTS may include a heat-conductive conduit thermally coupled to the UFC through a thermal interface material so as to exchange heat with fluid transported by the UFC to regulate an internal temperature of the equipment cabinet while the equipment cabinet remains under the ground.

## Description

### BACKGROUND

Outdoor outside-plant (OSP) cabinets are commonly installed above grade to house electronics such as power conversion, batteries, and communications equipment. Conventional assemblies employ environmental control systems typically HVAC or heat-exchanger units together with weatherproof coatings, filters, and thermal insulation to maintain equipment within specified limits under solar load, precipitation, salt, and wind. These solutions can introduce high energy consumption, acoustic emissions, periodic maintenance for filters and seals, and material sustainability concerns. Additionally, above-ground placements may occupy surface space and remain susceptible to accidental damage or vandalism.

### SUMMARY OF THE INVENTION

This summary is provided to introduce aspects related to an outside cabinet assembly configured for underground installation to house electronic equipment. In certain examples, a buried enclosure cooperates with environmental control features that leverage surrounding ground thermal stability and optional heat exchange with nearby utilities to regulate internal conditions. The arrangement may reduce reliance on high-power HVAC, damp acoustic emissions, and lessen the need for environmentally burdensome coatings or insulations. Further, situating the assembly below grade can preserve above-ground space, improve aesthetics and site security, and enhance reliability by mitigating solar loading and weather exposure.

In an aspect, an outside cabinet assembly is disclosed. The outside cabinet assembly may include a cavity formed under ground. The outside cabinet assembly may further include an enclosure received in the cavity. The outside cabinet assembly may further include an equipment cabinet received within the enclosure and configured to house electronic components. The outside cabinet assembly may further include an environmental control unit (ECU) thermally coupled to the equipment cabinet. The outside cabinet assembly may further include a utility fluid conveyance (UFC) disposed outside the enclosure. The outside cabinet assembly may further include a thermal transfer system (TTS) in fluid or thermal communication with the ECU and extending from the enclosure to the UFC disposed outside the enclosure. The TTS may include a heat-conductive conduit thermally coupled to the UFC through a thermal interface material so as to exchange heat with fluid transported by the UFC to regulate an internal temperature of the equipment cabinet while the equipment cabinet remains under the ground.

Other aspects and advantages of the invention will become apparent from the following description, taken in conjunction with the accompanying drawings, illustrating by way of example the principles of the invention.

### BRIEF DESCRIPTION OF THE DRAWINGS

The accompanying figures of the drawing, which are included to provide a further understanding of general aspects of the assembly, are incorporated in and constitute a part of this specification. If only the first numerical reference label is used in the specification, the description is applicable to any one of the similar components and/or features having the same first numerical reference label irrespective of the suffix.

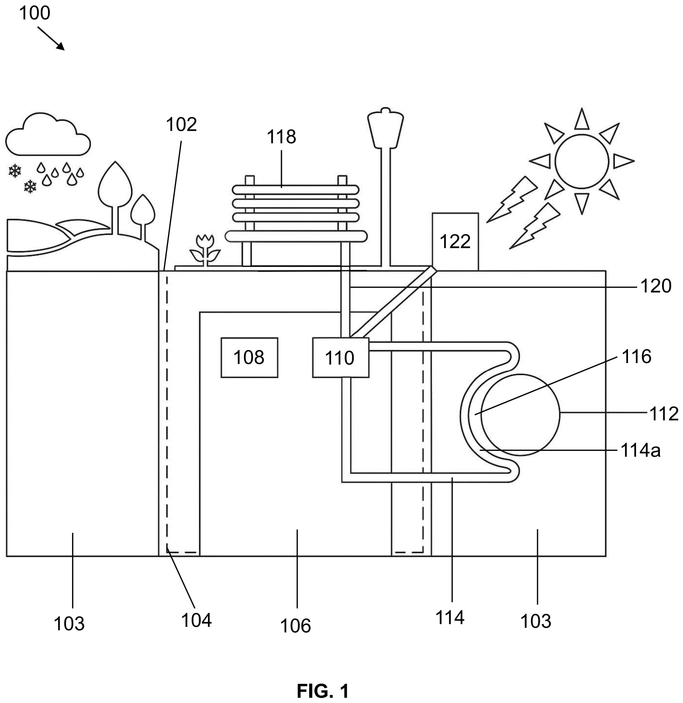

FIG. 1 illustrates an outside cabinet assembly, in accordance with an example of the present disclosure.

### DETAILED DESCRIPTION

Outdoor cabinet assemblies are commonly installed above-grade outside-plant cabinets to house electronic equipment, where solar loading, precipitation, salt, and wind drive internal temperature excursions. To remain within specification, conventional installations depend on energy-intensive HVAC or heat-exchanger units that add acoustic emissions, recurring maintenance, and materials such as coatings and insulations that raise sustainability concerns. Sites also consume valuable surface area and can be visually intrusive or prone to damage. Accordingly, there is a need for a configuration that maintains equipment conditions with lower energy and noise while improving environmental stewardship and site utilization.

The invention provides an outside cabinet assembly configured for underground installation to house and thermally manage electronic equipment. A cavity receives an enclosure that contains an equipment cabinet with an environmental control unit. To regulate temperature with reduced active cooling, a thermal transfer system extends from the enclosure to a nearby utility fluid conveyance, where a heat-conductive conduit is thermally coupled through a thermal interface material to exchange heat with fluid flowing in the conveyance. Other aspects include sensors and a controller to modulate operation, a heater utility connected by a thermal connection to reuse exhaust heat, and a backup radiator for peak conditions. This arrangement lowers energy use, dampens noise, reduces environmentally burdensome materials, and preserves surface usability. The invention, along with these and other aspects, will now be described in detail with reference to FIG. 1.

FIG. 1 illustrates an outside cabinet assembly 100, in accordance with an example of the present disclosure. The outside cabinet assembly 100 may include a cavity 102 formed under ground 103. In an example, the cavity 102 may be created by excavation using trenchers, augers, or backhoes, with temporary shoring or trench boxes employed when required by soil classification or code. The cavity 102 may be rectangular or cylindrical and sized to provide installation clearance for placement, leveling, and backfill compaction. The cavity floor can be graded and compacted to ≥95% relative compaction and may receive a leveling base such as crushed stone, a lean-concrete pad, or precast slab to distribute loads and resist settlement. Sidewalls may be lined with geotextile or moisture barriers to limit fines migration, and a perimeter drainage layer (e.g., washed gravel with perforated drain tile) can be provided where groundwater is present, with outlets directed to a dry well or storm line per local regulations. Backfill may include thermally stable materials (e.g., sand or pea gravel) compacted in lifts to restore native bearing capacity and enhance heat conduction to the surrounding soil. In coastal or high-water-table sites, the cavity can incorporate anti-buoyancy measures such as anchors or an increased foundation mass to prevent flotation during flood conditions. These construction options enable reliable, code-compliant formation of the cavity 102 under the ground 103 across a range of soil types and climates. In an example, the cavity 102 may be formed in ground 103.

The outdoor cabinet assembly 100 may further include an enclosure 104 received in the cavity 102. The cavity 102 positions the enclosure 104 at a predefined depth, and the enclosure 104 may include a moisture barrier and corrosion-resistant liner. In an example, the cavity 102 may be sized to provide installation clearance around the enclosure 104 (e.g., 50-200 mm radial) for alignment and backfill compaction, and leveling shims or adjustable feet can be used to hold the enclosure within ±5 mm of design elevation. The enclosure 104 may be formed of galvanized or powder-coated steel, aluminum alloy, fiber-reinforced polymer, or high-density polyethylene, and may incorporate a moisture barrier such as a continuous thermoplastic membrane, bituminous sheet, or spray-applied elastomer applied to the exterior surfaces to inhibit groundwater ingress. A corrosion-resistant liner can be provided on interior or exterior surfaces and may include epoxy or polyurethane coatings (e.g., ≥250 µm dry film thickness), anodized layers, or composite laminates selected to meet local soil corrosivity and stray-current exposure. Sealed seams, compression gaskets at penetrations, and drip edges may be used to achieve a targeted ingress rating (e.g., IP-rated interfaces where applicable). The depth is selected with reference to local frost line, load-bearing strata, and desired thermal stability, in typical deployments the top of the enclosure 104 is positioned at a predefined depth of about 0.5-3.0 m below grade to reduce diurnal temperature swing while preserving service access through a surface hatch or manway. Where groundwater is present, perimeter drainage media and weep paths may be provided adjacent the enclosure, and anti-buoyancy measures (e.g., ballast pad or anchors) may be used to resist uplift during flood conditions. This configuration enables durable placement of the enclosure 104 at the specified depth while limiting moisture intrusion and corrosion over the service life.

The outdoor cabinet assembly 100 may further include an equipment cabinet 106 received within the enclosure 104 and configured to house electronic components 108 such as power conversion modules, batteries, communication switches, and supervisory controls. In an example, the equipment cabinet 106 may provide standardized mounting (e.g., 19-inch or 23-inch rails), slide-out trays, and cable management with sealed penetrations and electromagnetic interference (EMI) gaskets to preserve environmental integrity. The equipment cabinet 106 can be supported on vibration-isolating mounts to limit structure-borne noise from rotating machinery within the enclosure. The enclosure 104 may include sound-attenuating wall structures surrounding the equipment cabinet 106 to reduce acoustic emissions at a predefined distance from ground level. For example, a double-wall construction with an air gap (e.g., 20-60 mm), an internal acoustic blanket (e.g., mineral wool or foam having a density of about 40-80 kg/m³), and a mass layer (e.g., mass-loaded vinyl or constrained-layer damping sheet). An interior perforated liner (e.g., 15-30% open area) may protect the absorbent media while promoting broadband attenuation. Where ventilation is provided, acoustically treated baffles or labyrinth paths may be used to impede line-of-sight transmission while maintaining required airflow. Seams and access panels may employ compression gaskets and latching hardware to sustain acoustic performance after service events.

The outdoor cabinet assembly 100 may further include an environmental control unit (ECU) 110 thermally coupled to the equipment cabinet 106 to regulate temperature and humidity of the electronic components 108. The ECU 110 may employ air-based conditioning (e.g., a vapor-compression circuit with variable-speed fan and condenser/evaporator coils) or liquid-based conditioning (e.g., a coolant loop with pump, plate heat exchanger, and expansion reservoir). Thermal coupling to the equipment cabinet 106 can be achieved via a ducted supply/return plenum directing conditioned air across heat-generating modules, via direct-contact cold plates or heat pipes fastened to component heat spreaders, or via a manifolded liquid loop interfacing with internal heat exchangers. The ECU 110 may incorporate closed-cell gaskets and insulated plenums to minimize bypass, condensate management features (e.g., drain pan and trap), and control logic (e.g., PID with hysteresis) that modulates compressor/fan or pump/valve duty to maintain a predefined internal temperature and relative-humidity band. In some examples, the ECU 110 operates across ambient conditions from about - 20 °C to 50 °C, with setpoints selected for electronics reliability (e.g., 20-35 °C), and may include overload/overtemperature safeties, serviceable filters, and quick-disconnect fittings to facilitate maintenance and integration with a thermal transfer pathway when provided.

The outside cabinet assembly 100 may further include a utility fluid conveyance (UFC) 112 disposed outside the enclosure 104. The UFC 112 may include a municipal pipe, waste-fluid line, or water supply line formed of concrete reinforced with steel or of metal having a predefined thermal conductivity. In an example, the UFC 112 may be an existing or newly installed buried pipeline such as a municipal water main, waste-fluid line, or service water line, and may be routed generally parallel to a sidewall of the enclosure with a design separation sufficient for construction access and code clearances. Suitable constructions include concrete pipe reinforced with steel (e.g., precast sections with corrosion-resistant rebar) or metallic pipework such as ductile iron, copper, stainless steel, or carbon steel selected to meet local pressure ratings and corrosion requirements. For thermal suitability, the UFC 112 may provide a wall thermal conductivity meeting a predefined threshold (e.g., at least about 1.0 W/m·K) and a nominal internal flow adequate to transport exchanged heat without exceeding utility temperature limits. Where present, external insulation or coatings on the UFC 112 may be omitted or locally modified within the designated coupling region to improve heat transfer while maintaining required protective barriers. Installation may include bedding and backfill per municipal standards, thrust restraint or anchorage at fittings, dielectric breaks where galvanic isolation is required, and compliance with separation distances from electrical and communications infrastructure. The UFC 112 can be operated within its normal utility temperature and pressure envelope, and no alteration of conveyed fluid chemistry is required for passive heat exchange.

The outside cabinet assembly 100 may further include a thermal transfer system (TTS) 114 in fluid or thermal communication with the ECU 110 and extending from the enclosure 104 to the UFC 112 disposed outside the enclosure 104. In an example, the TTS 114 may be implemented as a closed liquid loop having a pump, an expansion reservoir, a relief valve, and supply/return lines routed through sealed wall penetrations to a heat-exchange section proximate the UFC 112. Alternatively, the TTS 114 may employ a passive thermosyphon, heat-pipe manifold, or plate/coil heat exchanger mounted to transfer heat without active pumping. Piping for the TTS 114 can be copper, stainless steel, or multilayer polymer tubing rated for the expected temperature and pressure, with thermal insulation inside the enclosure to control condensation. Inlet and outlet temperature sensors and, when liquid is used, a flow sensor may provide inputs to a controller to modulate pump speed and control valves for staged or proportional heat transfer. Typical liquid flow rates may range from about 1-10 L/min with design temperature differentials of about 3-15 °C, selected to maintain target internal conditions while respecting limits of the UFC 112. Fittings can be brazed, welded, or compression-coupled; isolation valves and quick-disconnects facilitate service, and leak-detection provisions (e.g., drip tray with sensor) may be incorporated. The external run of the TTS 114 is routed to a designated coupling region adjacent the UFC 112 for thermal interaction, while maintaining required utility clearances and corrosion-protection practices. This arrangement establishes a controlled heat-transfer pathway between the ECU 110 and the UFC 112 to assist cabinet thermal regulation.

The TTS 114 may include a heat-conductive conduit 114a thermally coupled to the UFC 112 through a thermal interface material 116 so as to exchange heat with fluid transported by the UFC 112 to regulate an internal temperature of the equipment cabinet 106 while the equipment cabinet 106 remains under the ground 103. The TTS 114 may include a circulating heat-transfer fluid selected from water, water-glycol mixture, or dielectric cooling fluid. The heat-conductive conduit 114a of the TTS 114 may be wound at least partially around an exterior surface of the UFC 112 along a predefined coupling length to increase heat exchange. The thermal interface material 116 may include a high-conductivity layer selected from a group consisting of graphite sheet, silicone-based thermal pad, metal-filled epoxy, and phase-change material. The TTS 114 may further include a pump and a control valve regulated by the controller.

In an example, the conduit 114a may be copper, stainless steel, or aluminum tubing (e.g., 6-25 mm outside diameter, 0.5-1.5 mm wall) formed to wrap at least partially around the exterior of the UFC over a predefined coupling length (e.g., 0.5-5 m) with a wrap angle that can range from 90° to 720° depending on available circumference and required conductance. The thermal interface material 116 may be provided as a continuous layer between the conduit 114a and the UFC 112 to reduce contact resistance; suitable materials include graphite sheet, silicone-based thermal pad, metal-filled epoxy, or phase-change material with a through-plane thermal conductivity, for example, of at least about 2-10 W/m·K. The interface thickness may be on the order of 0.1-2.0 mm and may be compressed using band clamps or a split-sleeve fixture to achieve a target contact pressure (e.g., 50-300 kPa) without overstressing the UFC wall. To minimize galvanic effects where dissimilar metals are present, a dielectric barrier or compatible alloy selection can be employed outside the contact path of the thermal interface material 116. The TTS 114 may convey a circulating heat-transfer fluid-such as water, a water-glycol mixture, or a dielectric cooling fluid-driven by a pump sized for the loop head loss (e.g., 5-50 kPa at 1-10 L/min) with a control valve modulated by the controller to maintain a desired temperature differential across the conduit 114a (e.g., 3-15 °C). The loop may include supply/return lines routed from the ECU 110 to the coupling region, with insulation on portions not intended for heat exchange to limit parasitic losses and condensation. Surface preparation of the UFC 112 within the coupling region (e.g., coating removal, cleaning, and roughness control) can be performed to enhance interface conformity; protective top covers or jackets may be applied over the wrapped section to resist soil abrasion and moisture ingress while allowing heat flow. Temperature and, when applicable, flow sensors may provide feedback to the controller for proportional control of pump speed and valve position, ensuring that the UFC 112 remains within its utility temperature limits while the TTS 114 delivers the required thermal regulation of the equipment cabinet 106.

The outside cabinet assembly 100 may further include one or more sensors selected from a temperature sensor, a humidity sensor, and a flow sensor operably coupled to a controller configured to modulate operation of the ECU 110 and the TTS 114 based on sensed conditions. In an example, temperature sensing may be provided at multiple locations, for example in an airstream exiting the equipment cabinet 106, at an ECU return, and on a supply line of the TTS 114, suitable devices include thermistors, resistance temperature detectors (e.g., Class A Pt100/1000), or semiconductor sensors with ±0.3-0.5 °C accuracy over 0-60 °C. A humidity sensor may be positioned within the enclosure 104 air volume with a hydrophobic filter to protect against condensation and particulate, providing ±2-3% RH accuracy and dew-point estimation to prevent condensation on the electronic components 108. When the TTS 114 employs a circulating fluid, a flow sensor (e.g., turbine, Coriolis, or differential-pressure with calibrated orifice) can be installed on the supply or return line to verify commanded flow. The controller samples sensors at a defined interval (e.g., 1-10 s), applies signal filtering (e.g., moving average), and executes control logic such as hysteresis or proportional-integral-derivative routines to maintain target setpoints (e.g., 20-35 °C and 30-60% RH inside the equipment cabinet 106) while enforcing limits on the UFC 112 temperature rise. In operation, the controller may modulate the ECU 110 (e.g., compressor/fan speed or coolant pump rate) and the TTS 114 (e.g., pump speed and control valve position) to achieve a commanded temperature differential across the heat-conductive conduit 114a, with fallback states that prioritize safe operation. Alarms may be generated upon excursions such as over-temperature, low flow, sensor plausibility failure, or excessive condensation risk, with the controller placing the ECU 110 in a protective mode and, when provisioned, activating a backup radiator 122 if available. Suitable electrical interfaces include analog (e.g., 4-20 mA, 0-10 V) or digital buses (e.g., I²C, SPI, RS-485/Modbus) with ingress-protected connectors; sensors and wiring may be rated to applicable environmental standards to ensure reliable feedback for closed-loop thermal regulation.

The outside cabinet assembly 100 may further include a heater utility 118 located at or above grade and thermally connected to the ECU 110 by a thermal connection 120 so that exhausted heat from the ECU 100 is selectively delivered to the heater utility 118. The heated utility may include a bench, handrail, or walkway de-icing element. In an example, the thermal connection 120 may comprise an insulated supply/return loop or heat-pipe assembly routed from the ECU 110 to the heated utility 118 with control elements that enable or bypass heat delivery according to demand and ambient conditions. By way of example, a bench or handrail can incorporate internal channels or serpentine tubing to receive heat, while a walkway de-icing element may embed tubing beneath the surface to maintain the slab above freezing. The connection may employ quick-disconnect couplings and insulation along non-heating spans to minimize losses, and a controller may actuate a valve or pump to regulate heat flow to maintain a target surface temperature band (e.g., anti-icing setpoints) while enforcing safety limits for human contact. Freeze protection of the loop can be provided by glycol mixtures or standby circulation, and check valves may prevent reverse flow when the heated utility 118 is not energized.

The outside cabinet assembly 100 may further include a backup radiator 122 located outside the enclosure 104 and selectively coupled to the TTS 114 to dissipate heat when heat exchange with the UFC 112 is insufficient to maintain the internal temperature within a predetermined range. In an example, the backup radiator 122 may be a fin-tube, plate-fin, or microchannel heat exchanger fabricated from copper, aluminum, or stainless steel, and may operate by natural convection or include a low-noise axial fan for forced convection. Hydraulic coupling to the TTS 114 can be provided via a bypass manifold with isolation valves and a two- or three-way control valve that diverts a portion of loop flow through the backup radiator 122 when commanded by a controller based on sensed temperatures and flow. Example operating points include coolant flow of about 1-10 L/min and approach temperatures of about 3-10 °C relative to ambient air. To mitigate condensation and environmental exposure, the backup radiator 122 may incorporate corrosion-resistant coatings, insect screens, and a drip tray with drain routing away from the enclosure 104. Temperature sensors on the radiator inlet and outlet enable calculation of heat rejection, while a fan (if present) may be modulated to maintain target setpoints and minimize acoustic emissions. Quick-disconnect fittings and service shut-offs may be used to facilitate maintenance, and a pressure relief and air purge point may be provided at the radiator high point to aid commissioning. In operation, the controller may prioritize heat exchange with the UFC 112 and actuate the backup radiator 122 only during peak thermal loads, restricted utility conditions, or fault scenarios, thereby ensuring resilient thermal regulation of the equipment cabinet 106 without exceeding utility constraints.

In an exemplary operational scenario, the outside cabinet assembly 100 is commissioned with the enclosure 104 positioned within the cavity 102 under the ground 103, the equipment cabinet 106 populated with electronic components 108, and the ECU 110 and TTS 114 connected and leak-checked. Upon startup, a controller initializes sensors (temperature, humidity, and, when applicable, flow) and establishes target setpoints for internal temperature and relative humidity. During normal load and mild ambient conditions, the ECU 110 circulates air or coolant across heat-generating modules while the TTS 114 drives a circulating fluid through the heat-conductive conduit 114a, which is thermally coupled to the UFC 112 via the thermal interface material 116. Heat is passively rejected to fluid moving within the UFC 112, with the controller modulating pump speed and a control valve to maintain a commanded temperature differential while observing utility temperature rise limits.

Under higher thermal loads or peak daytime conditions, the controller increases TTS 114 flow until approaching predefined bounds; if the exchange capacity of the UFC 112 is insufficient, the controller selectively diverts loop flow through the backup radiator 122 to augment rejection and return the internal temperature of the equipment cabinet 106 to range. In cold weather, when anti-icing or occupant comfort is desired at grade, the controller actuates a valve or pump along the thermal connection 120 to route exhaust heat from the ECU 110 to a heated utility 118 such as a bench, handrail, or walkway de-icing element, while enforcing surface temperature and safety limits. Throughout operation, the controller applies hysteresis or proportional-integral-derivative routines, generates alarms on excursions (e.g., over-temperature, low flow, sensor fault), and transitions to safe states that prioritize protection of the electronic components 108. Periodic maintenance may include filter service for the ECU 110, inspection of the thermal interface material 116 and conduit 114a coupling region near the UFC 112, functional checks of the backup radiator 122, and verification of sensor calibration, thereby sustaining long-term thermal regulation performance while the equipment cabinet 106 remains under the ground 103.

Thus, the outside cabinet assembly 100 overcomes limitations of conventional above-grade installations by locating the enclosure 104 within the cavity 102 under the ground 103 and regulating conditions via the ECU 110 cooperating with the TTS 114 that exchanges heat with the nearby UFC 112 through the heat-conductive conduit 114a and the thermal interface material 116. This arrangement may reduce HVAC energy, damp acoustic emissions, and lessen reliance on environmentally burdensome coatings or insulations while preserving surface usability and improving site security. Optional sensors and the controller provide closed-loop modulation, the heated utility 118 enables selective reuse of exhaust heat, and the backup radiator 122 augments rejection during peaks, collectively enhancing reliability, serviceability, and sustainability across diverse deployments.

The methods, systems, devices, graphs, and/or tables discussed herein are examples. Various examples may omit, substitute, or add various procedures or components as appropriate. For instance, in alternative examples, the methods may be performed in an order different from that described, and/or various stages may be added, omitted, and/or combined. Also, features described with respect to certain examples may be combined in various other examples. Different aspects and elements of the examples may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

While illustrative and presently preferred examples of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as limitation on the scope of the disclosure.

Disclosed herein are also the following clauses:
1. An outside cabinet assembly, comprising: an enclosure received in a cavity under ground; an equipment cabinet received within an the enclosure and configured to house electronic components; an environmental control unit (ECU) thermally coupled to the equipment cabinet; and a thermal transfer system (TTS) in fluid or thermal communication with the ECU and extending from the enclosure to a utility fluid conveyance (UFC) buried outside the enclosure, wherein the TTS comprises a heat-conductive conduit thermally coupled to the UFC through a thermal interface material.
2. The outside cabinet assembly of clause 1, wherein the heat-conductive conduit of the TTS is wound at least partially around an exterior surface of the UFC along a predefined coupling length to increase heat exchange.
3. The outside cabinet assembly of clause 1, wherein the thermal interface material comprises a high-conductivity layer selected from a group consisting of graphite sheet, silicone-based thermal pad, metal-filled epoxy, and phase-change material.
4. The outside cabinet assembly of clause 1, wherein the enclosure comprises sound-attenuating wall structures surrounding the equipment cabinet.
5. The outside cabinet assembly of clause 1, further comprising one or more sensors selected from a temperature sensor, a humidity sensor, and a flow sensor operably coupled to a controller configured to modulate operation of the ECU and the TTS based on sensed conditions.
6. The outside cabinet assembly of clause 1, wherein the cavity positions the enclosure at a predefined depth, and the enclosure comprises a moisture barrier and corrosion-resistant liner.
7. The outside cabinet assembly of clause 1, wherein the UFC comprises a municipal pipe, waste-fluid line, or water supply line formed of concrete reinforced with steel or of metal having a predefined thermal conductivity.
8. The outside cabinet assembly of clause 1, further comprising a heated utility located at or above grade and thermally connected to the ECU by a thermal connection, the heated utility comprising a bench, handrail, or walkway de-icing element.
9. The outside cabinet assembly of clause 5, wherein the TTS comprises a circulating heat-transfer fluid selected from water, water-glycol mixture, or dielectric cooling fluid, and further comprises a pump and a control valve regulated by the controller.
10. The outside cabinet assembly of clause 1, further comprising a backup radiator located outside the enclosure and selectively coupled to the TTS to dissipate heat when heat exchange with the UFC is insufficient to maintain the internal temperature within a predetermined range.
Disclosed herein are also the following items:
1. An outside cabinet assembly, comprising: an enclosure received in a cavity under ground; an equipment cabinet received within the enclosure and configured to house electronic components; an environmental control unit,ECU, thermally coupled to the equipment cabinet; and a thermal transfer system,TTS, in fluid or thermal communication with the ECU and extending from the enclosure to a utility fluid conveyance, UFC, buried outside the enclosure, wherein the TTS comprises a heat-conductive conduit thermally coupled to the UFC through a thermal interface material.
2. The outside cabinet assembly of item 1, wherein the heat-conductive conduit of the TTS is wound at least partially around an exterior surface of the UFC along a predefined coupling length to increase heat exchange.
3. The outside cabinet assembly of any preceding item, wherein the thermal interface material comprises a high-conductivity layer selected from a group consisting of graphite sheet, silicone-based thermal pad, metal-filled epoxy, and phase-change material.
4. The outside cabinet assembly of any preceding item, wherein the enclosure comprises sound-attenuating wall structures surrounding the equipment cabinet.
5. The outside cabinet assembly of any preceding item, further comprising one or more sensors selected from a temperature sensor, a humidity sensor, and a flow sensor operably coupled to a controller configured to modulate operation of the ECU and the TTS based on sensed conditions.
6. The outside cabinet assembly of any preceding item, wherein the enclosure comprises a moisture barrier and corrosion-resistant liner.
7. The outside cabinet assembly of any preceding item, wherein the UFC comprises a municipal pipe, waste-fluid line, or water supply line formed of concrete reinforced with steel or of metal having a predefined thermal conductivity.
8. The outside cabinet assembly of any preceding item, further comprising a heated utility located at or above grade and thermally connected to the ECU by a thermal connection, the heated utility comprising a bench, handrail, or walkway de-icing element.
9. The outside cabinet assembly of item 5, wherein the TTS comprises a circulating heat-transfer fluid selected from water, water-glycol mixture, or dielectric cooling fluid, and further comprises a pump and a control valve regulated by the controller.
10. The outside cabinet assembly of any preceding item, further comprising a backup radiator located outside the enclosure and selectively coupled to the TTS to dissipate heat when heat exchange with the UFC is insufficient to maintain the internal temperature within a predetermined range.
11. The cabinet assembly of any preceding item, wherein the enclosure is received at a predefined depth; and wherein the enclosure comprises a moisture barrier based on the predefined depth and/or a corrosion-resistant liner based on the predefined depth.
12. The cabinet assembly of any preceding item, wherein the cabinet assembly is an outdoor outside-plant, OSP, cabinet.
13. The cabinet assembly of any preceding item, wherein the cabinet assembly is configured for installation under ground.
Described herein is also a cabinet assembly, comprising: an equipment cabinet received within an enclosure and configured to house electronic components; an environmental control unit (, ECU) , thermally coupled to the equipment cabinet; and a thermal transfer system (, TTS) , in fluid or thermal communication with the ECU and extending from the enclosure to a utility fluid conveyance (, UFC) , buried outside the enclosure, wherein the TTS comprises a heat-conductive conduit thermally coupled to the UFC through a thermal interface material.

## Claims

1. An outside cabinet assembly, comprising:
an enclosure received in a cavity under ground;
an equipment cabinet received within the enclosure and configured to house electronic components;
an environmental control unit, ECU, thermally coupled to the equipment cabinet; and
a thermal transfer system, TTS, in fluid or thermal communication with the ECU and extending from the enclosure to a utility fluid conveyance, UFC, buried outside the enclosure,
wherein the TTS comprises a heat-conductive conduit thermally coupled to the UFC through a thermal interface material.

2. The outside cabinet assembly of claim 1, wherein the heat-conductive conduit of the TTS is wound at least partially around an exterior surface of the UFC along a predefined coupling length to increase heat exchange.

3. The outside cabinet assembly of any preceding claim, wherein the thermal interface material comprises a high-conductivity layer selected from a group consisting of graphite sheet, silicone-based thermal pad, metal-filled epoxy, and phase-change material.

4. The outside cabinet assembly of any preceding claim, wherein the enclosure comprises sound-attenuating wall structures surrounding the equipment cabinet.

5. The outside cabinet assembly of any preceding claim, further comprising one or more sensors selected from a temperature sensor, a humidity sensor, and a flow sensor operably coupled to a controller configured to modulate operation of the ECU and the TTS based on sensed conditions.

6. The outside cabinet assembly of any preceding claim, wherein the enclosure comprises a moisture barrier and corrosion-resistant liner.

7. The outside cabinet assembly of any preceding claim, wherein the UFC comprises a municipal pipe, waste-fluid line, or water supply line formed of concrete reinforced with steel or of metal having a predefined thermal conductivity.

8. The outside cabinet assembly of any preceding claim, further comprising a heated utility located at or above grade and thermally connected to the ECU by a thermal connection, the heated utility comprising a bench, handrail, or walkway de-icing element.

9. The outside cabinet assembly of claim 5, wherein the TTS comprises a circulating heat-transfer fluid selected from water, water-glycol mixture, or dielectric cooling fluid, and further comprises a pump and a control valve regulated by the controller.

10. The outside cabinet assembly of any preceding claim, further comprising a backup radiator located outside the enclosure and selectively coupled to the TTS to dissipate heat when heat exchange with the UFC is insufficient to maintain the internal temperature within a predetermined range.

11. The cabinet assembly of any preceding claim,
wherein the enclosure is received at a predefined depth; and
wherein the enclosure comprises a moisture barrier based on the predefined depth and/or a corrosion-resistant liner based on the predefined depth.

12. The cabinet assembly of any preceding claim,
wherein the cabinet assembly is an outdoor outside-plant, OSP, cabinet.

13. The cabinet assembly of any preceding claim,
wherein the cabinet assembly is configured for installation under ground.
